# EUROPÄISCHE PATENTSCHRIFT

(11) **EP 1 155 482 B1**
(45) Veröffentlichungstag und Bekanntmachung des Hinweises auf die Patenterteilung: **04.05.2005**
(21) Anmeldenummer: 00916767.7
(22) Anmeldetag: 25.02.2000
(51) Int. Cl.: H01S 5/18

(54) **VERTIKALRESONATOR-LASERDIODE MIT EINER LICHTABSORBIERENDEN SCHICHT**
VERTICAL RESONATOR LASER DIODE WITH A LIGHT ABSORBING LAYER
DIODE LASER A RESONATEUR VERTICAL COMPORTANT UNE COUCHE D'ABSORPTION DE LUMIERE

(30) Priorität: 26.02.1999 DE 19908426
(43) Veröffentlichungstag der Anmeldung: 21.11.2001
(73) Patentinhaber: Infineon Technologies AG, 81669 München (DE)
(72) Erfinder: WIPIEJEWSKI, Torsten, D-93049 Regensburg (DE)
(74) Vertreter: Graf Lambsdorff, Matthias, Dr.
(86) Internationale Anmeldenummer: PCT/DE2000/000543
(87) Internationale Veröffentlichungsnummer: WO 2000/052793

(56) Entgegenhaltungen:
- EP-A- 0 892 473
- US-A- 5 745 515
- US-A- 5 838 715
- PATENT ABSTRACTS OF JAPAN vol. 014, no. 112 (E-0897), 28. Februar 1990 (1990-02-28) & JP 01 310585 A (MITSUBISHI ELECTRIC CORP), 14. Dezember 1989 (1989-12-14)
- BRIVIO F ET AL: "FEEDBACK EFFECTS IN OPTICAL COMMUNICATION SYSTEMS: CHARACTERISTIC CURVE FOR SINGLE-MODE INGAASP LASERS" APPLIED OPTICS,US,OPTICAL SOCIETY OF AMERICA,WASHINGTON, Bd. 31, Nr. 24, 20. August 1992 (1992-08-20), Seiten 5044-5050, XP000294668 ISSN: 0003-6935

## Beschreibung

Die Erfindung betrifft eine Vertikalresonator-Laserdiode nach dem Oberbegriff des Patentanspruchs 1.

Eine derartige Vertikalresonator-Laserdiode ist grundsätzlich aus der US-A-5,637,511 bekannt, die eine Struktur mit Bereichen hohen Widerstands zur Ladungsträgereinschnürung beschreibt, bei der die Lichtauskopplung durch das Substrat erfolgt.

Die Verwendung von Vertikalresonator-Laserdioden (VCSELs) in optischen Sendemodulen, wie z.B. PAROLI, erfordert oftmals einen relativ geringen differentiellen Quantenwirkungsgrad (DQE) des Bauelementes innerhalb enger Spezifikationsgrenzen. Dabei werden an die Reproduzierbarkeit der Fertigungsprozesse hohe Anforderungen gestellt. Zur Steigerung der Ausbeute wäre daher eine Einstellung des DQE nach dem epitaktischen Wachstum wahrend der Bauelemente-Prozessierung wünschenswert.

Ein weiteres Problem von VCSELs besteht darin, daß Reflexionen der VCSEL-Ausgangsstrahlung an nahen Oberflächen, wie z.B. der Glasfaser-Stirnfläche, zu einem großen Rauschen des Bauelementes führen können, was die Leistungsfähigkeit optischer Datenübertragungssysteme limitiert.

Der DQE von VCSELs wird bislang durch die Eigenschaften der Halbleiterschichten bestimmt, die während des epitaktischen Wachstums auf dem Wafer abgeschieden werden. Um einen relativ niedrigen DQE zu erreichen, werden beispielsweise eine große Zahl von Schichtpaaren im Auskoppelspiegel des VCSELs verwendet. Dadurch steigt jedoch die interne optische Intensität im Vergleich zu der externen Strahlungsstärke an, was sich nachteilig auf die Lebensdauer der Bauelemente auswirken kann.

Die Rückwirkungsempfindlichkeit von VCSELs wurde bislang allenfalls durch externe optische Elemente, wie teilverspiegelte Linsen, verringert. Optische Isolatoren, wie sie in der optischen Nachrichtentechnik Verwendung finden, scheiden für Datenverbindungen über kurze Entfernungen aus Kostengründen aus.

In der US-A-5838715 wird eine VCSEL-Laserdiode beschrieben, bei deren Betrieb die Entstehung von Schwingungsmoden höherer Ordnung dadurch vermieden wird, daß an der Lichtaustrittsseite der Diode ein verlustbestimmendes Element an die optische Kavität angekoppelt wird, bei der der Verlust der Lichtleistung durch Absorption mit zunehmendem lateralem Abstand von der optischen Achse zunimmt. Das verlustbestimmende Element ist im einfachsten Fall als eine Vertiefung ausgebildet, die einen kurvenförmigen Verlauf mit einem Minimum an der optischen Achse aufweist.

Die EP-A-892473 beschreibt einen Halbleiterlaser, welcher zur Reduzierung der emittierten Strahlungsmenge an der Lichtaustrittsseite eine transparente Linsenkappe mit einer partiell reflektierenden Beschichtung aufweist.

Die US-A-5745515 offenbart einen VCSEL-Halbleiterlaser, welcher in einer der beiden Reflektorspiegelfolgen eine Viertelwellenlängenschicht aufweist, die als eine Absorptionsschicht des Halbleiterlasers wirkt und somit die emittierte Lichtleistung des Halbleiter-Lasers effektiv begrenzt.

Demgemäß liegt der vorliegenden Erfindung die Aufgabe zugrunde, eine Vertikalresonator-Laserdiode zu schaffen, bei welcher der differentielle Quantenwirkungsgrad gezielt eingestellt werden kann und gleichzeitig die Rückwirkungsempfindlichkeit verringert werden kann.

Diese Aufgabe wird durch die Merkmale des Patentanspruchs 1 gelöst.

In der hier zu beschreibenden Erfindung wird der nach außen sichtbare, externe DQE durch mindestens eine absorbierende Schicht verringert, die in der Umgebung der Oberfläche der Vertikalresonator-Laserdiode (VCSEL) angeordnet ist. Die absorbierende Schicht reduziert die Zahl der nach außen gelangenden Photonen durch Fundamentalabsorption.

Die Erzeugung der lichtabsorbierenden Schicht kann grundsätzlich auf zwei unterschiedliche Arten in den Herstellungsprozeß des VCSEL eingebunden werden.

In der ersten Ausführungsart wird die lichtabsorbierende Schicht gewissermaßen in den VCSEL monolithisch integriert, d.h. sie wird direkt im Anschluß an die Aufbringung der lichtaustrittsseitigen Bragg-Reflektor-Schichtenfolge vorzugsweise mit ein- und demselben Wachstumsverfahren mit einer bestimmten Dicke auf diese aufgewachsen. Daran anschließend wird eine lichtaustrittsseitige elektrische Kontaktschicht auf die lichtabsorbierende Schicht aufgebracht und mit einer Lichtaustrittsöffnung versehen. Dann wird die Lichtleistung des VCSEL gemessen und der differentielle Quantenwirkungsgrad bestimmt. Abwechselnd wird dann die lichtabsorbierende Schicht im Bereich der Lichtaustrittsöffnung abgeätzt und die Lichtleistung gemessen und dieser Verfahrensschritt wird so lange fortgesetzt, bis der gewünschte differentielle Quantenwirkungsgrad erreicht ist.

In der zweiten Ausführungsart wird der VCSEL fertigprozessiert und die lichtabsorbierende Schicht wird nachträglich auf die lichtaustrittsseitige elektrische Kontaktschicht aufgebracht. Die Einstellung der geeigneten Dicke kann wiederum auf zwei unterschiedliche Arten erfolgen. Die lichtabsorbierende Schicht kann zum einen wie in der ersten Ausführungsart mit einer bestimmten ausreichenden Dicke aufgebracht und alternierend mit Lichtleistungsmessungen abgeätzt werden. Die lichtabsorbierende Schicht kann zum anderen schrittweise mit geringen Schichtdickeninkrementen und alternierend mit Lichtleistungsmessungen aufgebracht werden.

Für die in der heutigen optischen Datenübertragung wichtige Wellenlänge von 850nm kann in der ersten Ausführungsart als absorbierende Schicht z.B. eine bis zu mehrere µm dicke GaAs-Schicht verwendet werden. In der zweiten Ausführungsart kann beispielsweise amorphes Silizium durch ein geeignetes Abscheideverfahren aufgebracht werden.

Die absorbierende Schicht verringert neben dem differentiellen Quantenwirkungsgrad auch gleichzeitig die externe Steilheit des Bauelementes, ohne die interne Photonendichte nennenswert zu erhöhen. Außerdem werden externe Reflexionen, die in den optischen Resonator des VCSELs zurückfallen, von dieser absorbierenden Schicht gedämpft, so daß eine verbesserte Stabilität des Bauelementes gegenüber externen Rückwirkungen gegeben ist.

Im folgenden werden die zwei Ausführungsarten der vorliegenden Erfindung anhand der in den Figuren dargestellten fertigprozessierten VCSELs näher erläutert. Es zeigen:
Fig.1 den epitaktischen Schichtaufbau einer erfindungsgemäßen Vertikalresonator-Laserdiode, die nach der ersten Ausführungsart hergestellt wurde;
Fig.2 den epitaktischen Schichtaufbau einer erfindungsgemäßen Vertikalresonator-Laserdiode, die nach der zweiten Ausführungsart hergestellt wurde;

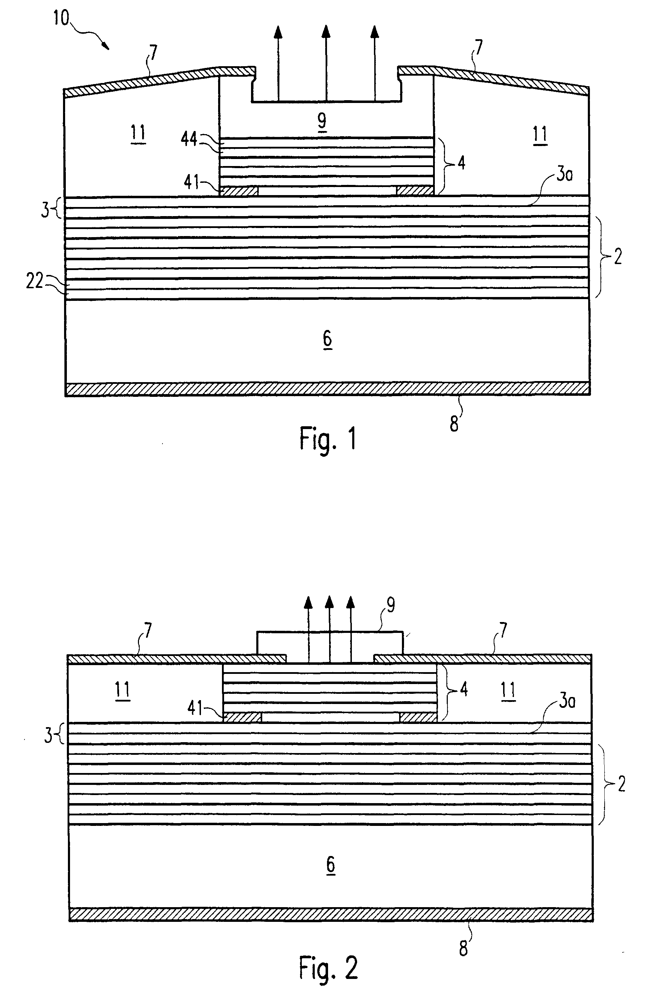

Die erste Ausführungsart gemäß Fig.1 zeigt den epitaktischen Schichtaufbau einer erfindungsgemäßen Vertikalresonator-Laserdiode 10, bei der eine lichtabsorbierende Schicht 9 in die Laserdiode monolithisch integriert ist.

Auf einem GaAs-Substrat 6 befindet sich eine erste, untere Bragg-Reflektor-Schichtenfolge 2, die aus einzelnen identischen Spiegelpaaren 22 aufgebaut ist. Die Spiegelpaare bestehen jeweils aus zwei AlGaAs-Schichten unterschiedlicher Bandlücke. In gleicher Weise ist eine zweite, obere Bragg-Reflektor-Schichtenfolge 4 aus entsprechenden Spiegelpaaren 44 aufgebaut. Zwischen der unteren und der oberen Bragg-Reflektor-Schichtenfolge ist eine aktive Schichtenfolge 3 eingebettet, die eine aktive Zone 3a aufweist. In dem dargestellten Ausführungsbeispiel beträgt die Emissionswellenlänge der Laserdiode 850 nm. Auf der oberen Oberfläche der Laserdiode 10 befindet sich eine erste Metallisierungsschicht 7, die für den elektrischen Anschluß der p-dotierten Seite der Laserdiode 10 verwendet wird. Die erste Metallisierungsschicht 7 weist eine zentrale Öffnung für den Durchtritt der Laserstrahlung auf. Die n-dotierte Seite der Diode wird üblicherweise über eine am Substrat 6 kontaktierte zweite Metallisierungsschicht 8 elektrisch angeschlossen.

Die obere Bragg-Reflektor-Schichtenfolge 4 enthält in dem Ausführungsbeispiel ein Spiegelpaar 44, welches eine sogenannte Stromapertur 41 enthält. Die Stromapertur 41 sorgt für eine laterale Strombegrenzung und definiert damit die eigentliche aktive lichtemittierende Fläche in der aktiven Zone 3a. Der Stromfluß wird auf den Öffnungsbereich der Stromapertur 41 beschränkt. Somit liegt die lichtemittierende Fläche direkt unterhalb dieses Öffnungsbereichs in der aktiven Zone 3a. Die Stromapertur 41 kann in bekannter Weise durch partielle Oxidation der AlGaAs-Schichten des betreffenden Spiegelpaares oder durch Ionen- oder Protonenimplantation hergestellt werden.

Die obere Bragg-Reflektor-Schichtenfolge 4 der Laserdiode 10 ist in Form einer Mesa-Struktur oberhalb der aktiven Schicht 3 strukturiert. Die mesaförmige obere Bragg-Reflektor-Schichtenfolge 4 wird seitlich durch eine geeignete Passivierungsschicht 11 umschlossen.

Oberhalb der oberen Bragg-Reflektor-Schichtenfolge 4 ist eine lichtabsorbierende Schicht 9 aufgebracht, durch die eine gezielte Abschwächung der emittierten Lichtstrahlung durch Lichtabsorption eingestellt werden kann. Mit dieser Schicht 9 kann somit der differentielle Quantenwirkungsgrad (DQE) der Laserdiode gezielt eingestellt werden. Bei einer Emissionswellenlänge von 850 nm - wie im vorliegenden Ausführungsbeispiel - bietet sich als Material für die lichtabsorbierende Schicht 9 GaAs mit einer Schichtdicke in der Größenordnung von einigen µm an. Die GaAs-Schicht wird vorzugsweise mit den anderen Halbleiterschichten der Laserdiode zusammen aufgewachsen. Als Wachstumsverfahren dient MBE (Molekularstrahlepitaxie) oder MOCVD (metallorganische Gasphasenepitaxie). Obwohl die gewünschte Schichtdicke durch Einstellung der Wachstumsparameter relativ genau eingestellt werden kann, ist der differentielle Quantenwirkungsgrad das Produkt mehrerer Faktoren wie z.B. der Materialabsorption, die wiederum von der Dotierung abhängig ist. Daher erfolgt die Einstellung der DQE dadurch, daß die lichtabsorbierende Schicht 9 zunächst mit einer hinreichenden Schichtdicke aufgewachsen und anschließend teilweise wieder abgeätzt wird.

Das Bauelement wird also zunächst fertiggestellt und die emittierte Lichtleistung wird gemessen und daraus wird der DQE ermittelt. Dann wird die lichtabsorbierende Schicht im Bereich der Lichtaustrittsöffnung der ersten elektrischen Kontaktschicht teilweise abgeätzt, wobei die aufgebrachte Metallisierungsschicht 7 als Ätzmaske wirken kann. Bei dem in Fig.1 dargestellten Bauelement ist die in die GaAs-Schicht 9 geätzte Vertiefung und die geringfügigen Unterätzungen im Randbereich der Lichtaustrittsöffnung zu erkennen.

Die Herstellung der Mesa-Struktur der Laserdiode und die Erzeugung der Oxidapertur 41 erfolgt nach dem Aufwachsen der lichtabsorbierenden Schicht 9. Dann wird die Struktur mit der Passivierungsschicht 11 planarisiert und die erste Kontaktschicht 7 aufgebracht, worauf - wie bereits beschrieben - die Einstellung der Schichtdicke der lichtabsorbierenden Schicht durchgeführt wird.

In Fig.2 ist eine erfindungsgemäße Vertikalresonator-Laserdiode 20 dargestellt, die nach der zweiten Ausführungsart hergestellt wurde. Der Einfachheit halber sind für funktions- oder bedeutungsgleiche Elemente wie in Fig.1 die gleichen Bezugsziffern gewählt worden und deren Erläuterung wird hier weggelassen.

Bei dieser Ausführungsart wird der VCSEL fertigprozessiert und auf die lichtaustrittsseitige Bragg-Reflektor-Schichtenfolge 4 wird die erste elektrische Kontaktschicht 7 mit der Lichtaustrittsöffnung aufgebracht. Gewünschtenfalls kann zunächst die Lichtleistung gemessen und der DQE des VCSEL bestimmt. Danach erfolgt die Aufbringung der lichtabsorbierenden Schicht 9, die in dieser Ausführungsart beispielsweise aus amorphem Silizium bestehen kann. Diese wird zunächst mit einem geeigneten Abscheideverfahren wie z.B. Aufdampfen auf die Lichtaustrittsöffnung aufgebracht. Vorzugsweise wird die Schicht 9 durch eine geeignete Maskierung oder durch Lift-Off-Technik derart aufgebracht, daß sie die Lichtaustrittsöffnung bedeckt und die erste Kontaktierungsschicht 7 im Randbereich geringfügig überlappt.

Die geeignete Schichtdicke der lichtabsorbierenden Schicht 9 kann durch wechselweises Aufbringen der Schicht und Messen der Lichtleistung eingestellt werden, wobei der Verfahrensschritt beendet wird, wenn der gewünschte DQE erreicht ist. Es kann aber auch wie bei der ersten Ausführungsart zuerst eine ausreichende Schichtdicke aufgebracht werden und anschließend durch wechselweises Abätzen und Messen der Lichtleistung die geeignete Schichtdicke eingestellt werden.

## Patentansprüche

1. Vertikalresonator-Laserdiode (10, 20), bei der
- zwischen einer ersten Bragg-Reflektor-Schichtenfolge (2) und einer zweiten Bragg-Reflektor-Schichtenfolge (4), von denen jede eine Mehrzahl von Spiegelpaaren (22, 44) aufweist, eine aktive Schichtenfolge (3) zur Erzeugung von Laserstrahlung angeordnet ist,
- die beiden Bragg-Reflektor-Schichtenfolgen (2, 4) einen Laser-Resonator bilden,
- die beiden Bragg-Reflektor-Schichtenfolgen (2, 4) und die aktive Schichtenfolge (3) zwischen einer ersten (7) und einer zweiten elektrischen Kontaktschicht (8) angeordnet sind,
- eine (4) der beiden Bragg-Reflektor-Schichtenfolgen (2, 4) für die in der aktiven Schichtenfolge (3) erzeugte Laserstrahlung teildurchlässig ist,
**dadurch gekennzeichnet, daß**
- mindestens eine lichtabsorbierende Schicht (9) mit einer vorgegebenen Lichtabsorption auf der Lichtaustrittsseite der teildurchlässigen Bragg-Reflektor-Schichtenfolge (4) angeordnet ist.

2. Vertikalresonator-Laserdiode (10) nach Anspruch 1,
**dadurch gekennzeichnet, daß**
- die lichtabsorbierende Schicht (9) zwischen der teildurchlässigen Bragg-Reflektor-Schichtenfolge (4) und der ersten elektrischen Kontaktschicht (7) angeordnet ist.

3. Vertikalresonator-Laserdiode (20) nach Anspruch 1,
**dadurch gekennzeichnet, daß**
- die lichtabsorbierende Schicht (9) auf der Lichtaustrittsseite der ersten elektrischen Kontaktschicht (7) aufgebracht ist.

4. Vertikalresonator-Laserdiode (10, 20) nach Anspruch 2 oder 3,
**dadurch gekennzeichnet, daß**
- die lichtabsorbierende Schicht (9) im Bereich einer in der Kontaktschicht (7) geformten Lichtauatrittsöffnung mit einer vorgegebenen, die Lichtabsorption bestimmenden Schichtdicke angeordnet ist.

5. Verfahren zur Herstellung einer Vertikalresonator-Laserdiode nach Anspruch 1 bis 3, bei welchem
- auf ein Halbleitersubstrat nacheinander die erste Bragg-Reflektor-Schichtenfolge, die aktive Schichtenfolge und die zweite Bragg-Reflektor-Schichtenfolge aufgebracht wird,
- auf die zweite Bragg-Reflektor-Schichtenfolge die erste elektrische Kontaktschicht mit einer Lichtaustrittsöffnung aufgebracht wird, und auf die Substratrückseite die zweite elektrische Kontaktschicht aufgebracht wird,
- im Bereich der Lichtaustrittsöffnung die lichtabsorbierende Schicht aufgebracht wird, wobei
- entweder die lichtabsorbierende Schicht mit einer bestimmten Dicke aufgebracht, die Lichtleistung gemessen und der differentielle Quantenwirkungsgrad bestimmt wird und die lichtabsorbierende Schicht im Bereich der Lichtaustrittsöffnung so lange abgeätzt wird, bis ein gewünschter differentieller Quantenwirkungsgrad erreicht ist,
- oder die lichtabsorbierende Schicht schrittweise aufgebracht wird, wobei zwischendurch die Lichtleistung gemessen und der differentielle Quantenwirkungsgrad bestimmt wird, und der Verfahrensschritt beendet wird, sobald ein gewünschter differentieller Quantenwirkungsgrad erreicht ist.

## Claims

1. Vertical resonator laser diode (10, 20), in which
- an active layer sequence (3) for generating laser radiation is arranged between a first Bragg reflector layer sequence (2) and a second Bragg reflector layer sequence (4) each of which has a plurality of mirror pairs (22, 44),
- the two Bragg reflector layer sequences (2, 4) form a laser resonator,
- the two Bragg reflector layer sequences (2, 4) and the active layer sequence (3) are arranged between a first (7) and a second electrical contact layer (8),
- one (4) of the two Bragg reflector layer sequences (2, 4) is partly transmissive to the laser radiation generated in the active layer sequence (3),
**characterized in that**
- at least one light-absorbing layer (9) with a predetermined light absorption is arranged on the light exit side of the partly transmissive Bragg reflector layer sequence (4).

2. Vertical resonator laser diode (10) according to Claim 1,
**characterized in that**
- the light-absorbing layer (9) is arranged between the partly transmissive Bragg reflector layer sequence (4) and the first electrical contact layer (7).

3. Vertical resonator laser diode (20) according to Claim 1,
**characterized in that**
- the light-absorbing layer (9) is applied on the light exit side of the first electrical contact layer (7).

4. Vertical resonator laser diode (10, 20) according to Claim 2 or 3,
**characterized in that**
- the light-absorbing layer (9) is arranged in the region of a light exit opening - formed in the contact layer (7) - with a predetermined layer thickness that determines the light absorption.

5. Method for producing a vertical resonator laser diode according to Claims 1 to 3, in which
- the first Bragg reflector layer sequence, the active layer sequence and the second Bragg reflector layer sequence are applied successively to a semiconductor substrate,
- the first electrical contact layer with a light exit opening is applied to the second Bragg reflector layer sequence, and the second electrical contact layer is applied to the rear side of the substrate,
- the light-absorbing layer is applied in the region of the light exit opening,
- either the light-absorbing layer being applied with a specific thickness, the light power being measured and the differential quantum efficiency being determined and the light-absorbing layer being etched away in the region of the light exit opening until a desired differential quantum efficiency is reached,
- or the light-absorbing layer being applied progressively, in the meantime the light power being measured and the differential quantum efficiency being determined, and the method step being ended as soon as a desired differential quantum efficiency is reached.

## Revendications

1. Diode laser à résonateur vertical (10, 20), dans laquelle
- une succession de couches active (3) pour la production d'un rayonnement laser est placée entre une première succession de couches à réflecteur de Bragg (2) et une deuxième succession de couches à réflecteur de Bragg (4) dont chacune comporte plusieurs paires de miroirs (22, 44),
- les deux successions de couches à réflecteur de Bragg (2, 4) forment un résonateur laser,
- les deux successions de couches à réflecteur de Bragg (2, 4) et la succession de couches active (3) sont placées entre une première (7) et une deuxième (8) couche de contact électrique,
- l'une (4) des deux successions de couches à réflecteur de Bragg (2, 4) est partiellement transparente au rayonnement laser produit dans la succession de couches active (3),
**caractérisée par le fait que**
- au moins une couche (9) absorbant la lumière et ayant une absorption de lumière prédéterminée est placée du côté de la sortie de lumière de la succession de couches à réflecteur de Bragg (4) partiellement transparente.

2. Diode laser à résonateur vertical (10) selon la revendication 1,
**caractérisée par le fait que**
- la couche (9) absorbant la lumière est placée entre la succession de couches à réflecteur de Bragg (4) partiellement transparente et la première couche de contact électrique (7).

3. Diode laser à résonateur vertical (20) selon la revendication 1,
**caractérisée par le fait que**
la couche (9) absorbant la lumière est appliquée du côté de la sortie de lumière de la première couche de contact électrique (7).

4. Diode laser à résonateur vertical (10, 20) selon la revendication 2 ou 3,
**caractérisée par le fait que**
- la couche (9) absorbant la lumière est placée dans la zone d'un orifice de sortie de lumière formé dans la couche de contact (7) avec une épaisseur de couche prédéterminée qui détermine l'absorption de lumière.

5. Procédé de fabrication d'une diode laser à résonateur vertical selon la revendication 1 à 3, dans lequel
- on applique successivement sur un substrat semi-conducteur la première succession de couches à réflecteur de Bragg, la succession de couches active et la deuxième succession de couches à réflecteur de Bragg,
- on applique la première couche de contact électrique avec un orifice de sortie de lumière sur la deuxième succession de couches à réflecteur de Bragg et on applique la deuxième couche de contact électrique sur l'arrière du substrat,
- on applique la couche absorbant la lumière dans la zone de l'orifice de sortie de lumière, à savoir :
- soit on applique la couche absorbant la lumière avec une certaine épaisseur, on mesure la puissance lumineuse et on détermine le rendement quantique différentiel et on corrode la couche absorbant la lumière dans la zone de l'orifice de sortie de lumière jusqu'à atteindre un rendement quantique différentiel souhaité,
- soit on applique par étapes la couche absorbant la lumière, la puissance lumineuse étant mesurée et le rendement quantique différentiel étant déterminé entre les étapes, et on met fin au processus dès qu'un rendement quantique différentiel souhaité est atteint.
